# EUROPÄISCHE PATENTSCHRIFT

(11) **EP 2 308 065 B1**
(45) Veröffentlichungstag und Bekanntmachung des Hinweises auf die Patenterteilung: **30.08.2017**
(21) Anmeldenummer: 09781049.3
(22) Anmeldetag: 24.07.2009
(51) Int. Cl.: H01G 4/40, H03H 7/01, H01C 7/12

(54) **VIELSCHICHTBAUELEMENT**
MULTILAYER COMPONENT
COMPOSANT MULTICOUCHE

(30) Priorität: 28.07.2008 DE 102008035102
(43) Veröffentlichungstag der Anmeldung: 13.04.2011
(73) Patentinhaber: Epcos AG, 81669 München (DE)
(72) Erfinder: FEICHTINGER, Thomas, A-8010 Graz (AT); BRUNNER, Sebastian, A-8042 Graz (AT)
(74) Vertreter: Epping - Hermann - Fischer
(86) Internationale Anmeldenummer: PCT/EP2009/059577
(87) Internationale Veröffentlichungsnummer: WO 2010/012661

(56) Entgegenhaltungen:
- WO-A1-97/36307
- GB-A- 2 419 034
- JP-A- 4 257 111
- JP-A- 2000 077 265
- JP-A- 2002 151 354
- JP-A- 2002 222 712
- JP-A- 2004 203 631
- JP-A- 2006 311 203

## Beschreibung

Aus der Druckschrift DE 102005025680 A1 ist ein Vielschichtbauelement mit einem Varistor und einem LC-Filter bekannt.

In JP 2002 222712 A ist ein LC-Bauelement beschrieben, bei dem eine ebene Induktivität auf der Oberseite eines Kondensators zwischen magnetischen Filmen aus Ferrit angeordnet ist.

In WO 97/36307 A1 ist ein LC-Bauelement beschrieben, bei dem eine Induktivität aus einer Elektrodenschicht gebildet ist, die zwischen ferromagnetischen Bereichen angeordnet ist.

In JP 04 257111 A ist ein Pi-Filter-Bauelement beschrieben, das aus Varistorschichten und Ferritschichten gebildet ist.

In GB 2 419 034 A ist ein LC-Filter-Bauelement mit Varistorfunktion beschrieben.

In JP 2002 151354 A ist ein LC-Bauelement in Schichtbauweise beschrieben, das NiO enthält.

Eine zu lösende Aufgabe ist es, ein Vielschichtbauelement anzugeben, das ein weites Spektrum an möglichen LC-Filterdesigns ermöglicht.

Die Aufgabe wird durch ein Vielschichtbauelement nach Patentanspruch 1 gelöst. Vorteilhafte Ausgestaltungen des Vielschichtbauelements sind Gegenstand von Unteransprüchen.

Es wird ein Vielschichtbauelement angegeben, das wenigstens einen induktiven Bereich und wenigstens einen kapazitiven Bereich aufweist. Der induktive Bereich umfasst eine Ferritkeramik. Auf der nach außen gewandten Oberseite des induktiven Bereichs sind Elektrodenstrukturen angeordnet. Die Elektrodenstrukturen bilden wenigstens eine Spulenstruktur, welche eine Induktivität umfasst.

Die Spulenstruktur liegt vorzugsweise in einer Ebene. In einer Ausführungsform ist die Spulenstruktur auf der Ferritkeramik aufgebracht. Die Spulenstruktur weist eine spiralförmige, von innen nach außen verlaufende Form auf. Die Spulenstruktur weist spiralförmig verlaufende Bahnen auf. Die Bahnen weisen im Querschnitt vorzugsweise eine größere Breite als Höhe auf.

Die Spulenstruktur, die in einer nach außen gewandten Oberseite des induktiven Bereichs des Vielschichtbauelements angeordnet ist, umfasst eine oder mehrere der folgenden Metalle: Kupfer, Silber, Palladium oder Platin. Die Spulenstruktur kann auch weitere geeignete Metalle umfassen.

In einer Ausführungsform weist die Spulenstruktur die Form einer Spirale auf. Die Spulenstruktur kann jedoch auch jede geeignete Struktur aufweisen, die dazu geeignet ist, die Funktion der Spule zu übernehmen.

Die Spulenstruktur auf dem induktiven Bereich des Vielschichtbauelements wird vorzugsweise in einem fotolithografischen Verfahren, wie beispielsweise einem Photo-Laser-Imaging-Verfahren, auf der nach außen gewandten Oberseite des induktiven Bereichs aufgebaut.

Die Spulenstruktur wird vorzugsweise mittels einer Passivierungsschicht überdeckt. Die Passivierungsschicht kann beispielsweise ein Polymer oder ein Glas umfassen. Die Passivierungsschicht kann beispielsweise mittels eines Siebdruckverfahrens oder mittels Sprühen auf der Oberseite des Bauelements aufgebracht sein.

Darüber hinaus kann der induktive Bereich weitere Elektrodenstrukturen aufweisen, die im Inneren des induktiven Bereichs angeordnet sind.

Der kapazitive Bereich des Vielschichtbauelements weist mehrere Innenelektroden auf. Durch die Innenelektroden des kapazitiven Bereichs sind wenigstens eine Kapazität und wenigstens ein nichtlinearer Widerstand umfasst.

Die Elektrodenstrukturen des induktiven Bereichs sowie die Innenelektroden des kapazitiven Bereichs sowie gegebenenfalls weitere Innenelektroden des induktiven Bereichs umfassen Leiterbahnen und Durchkontaktierungen.

Unter Durchkontaktierungen sind elektrisch leitende Verbindungen zwischen zwei oder mehr Leiterbahnen auf unterschiedlichen Ebenen zu verstehen. Mittels einer Durchkontaktierung lässt sich beispielsweise eine Leiterbahn auf einer ersten Ebene mit einer weiteren Leiterbahn auf einer zweiten darüber oder darunter angeordneten Ebene elektrisch leitend miteinander verbinden.

In einer bevorzugten Ausführungsform weisen die Durchkontaktierungen eine konische Form auf. Konische Durchkontaktierungen können beispielsweise mittels konischer Nadeln oder mittels eines Lasers in den Grünfolien eines Vielschichtbauelements erzeugt werden. Vielschichtbauelemente werden häufig mittels übereinander gestapelter, so genannter Grünfolien hergestellt. Auf den Grünfolien sind beispielsweise mittels Siebdruck Leiterbahnen aufgedruckt. Der Stapel bedruckter Grünfolien wird anschließend bei hohen Temperaturen in einem Ofen gesintert.

Durch konische Durchkontaktierungen ist es beispielsweise möglich, dass breite Leiterbahnen auf einer ersten Seite einer Schicht des Vielschichtbauelements mit relativ schmalen nahe beieinander liegenden Leiterbahnen auf einer zweiten Seite der Schicht kontaktiert werden können. Dadurch ist beim Design der Leiterbahnen eine größere Gestaltungsfreiheit möglich.

In einer weiteren Ausführungsform können beispielsweise die konusförmigen Durchkontaktierungen zweier übereinander liegender Schichten mit den Spitzen zueinander gerichtet sein. Dadurch kann beispielsweise eine Kontaktierung von einer breiten über eine relativ schmale Leiterbahn hin zu einer wiederum breiten Leiterbahn erfolgen. Erfindungsgemäss umfasst der kapazitive Bereich eine Varistorkeramik oder eine Kondensatorkeramik. In einer Ausführungsform kann die Ferritkeramik des induktiven Bereichs Nickelzinkferrite (NiZn), Nickelkupferzinkferrite (NiCuZn) oder Nickelzinkkobaltferrite (NiZnCo) umfassen.

In einer weiteren Ausführungsform kann die Ferritkeramik des induktiven Bereichs hexagonale Ferrite umfassen.

Durch die Verwendung einer Ferritkeramik für den Aufbau der Induktivität können sehr hohe Induktivitäten erreicht werden, weil Ferritkeramiken im Vergleich zu herkömmlichen Vielschichtbauelementen eine wesentlich höhere Permeabilität aufweisen. Die Ferritkeramiken des Vielschichtbauelements weisen vorzugsweise eine Permeabilität auf, die größer als 1 ist. Vorzugsweise weist die Ferritkeramik eine Permeabilität zwischen 1 und 50 auf.

In einer Ausführungsform kann die Varistorkeramik des kapazitiven Bereichs eine Zinkoxidbismutantimon (ZnO-Bi-Sb)-Keramik oder eine Zinkoxidpraseodym (ZnO-Pr) -Keramik umfassen.

In einer Ausführungsform kann die Kondensatorkeramik des kapazitiven Bereichs eine NPO-Keramik umfassen.

In einer Ausführungsform bilden wenigstens eine Induktivität des induktiven Bereichs und wenigstens eine Kapazität des kapazitiven Bereichs des Vielschichtbauelements eine LC-Filterstruktur. Die LC-Filterstruktur kann eine T-LC-Filterstruktur oder eine Pi-LC-Filterstruktur aufweisen.

In einer Ausführungsform kann das Vielschichtbauelement zwischen dem kapazitiven und dem induktiven Bereich eine metallische Schicht aufweisen. Die metallische Zwischenschicht dient vorzugsweise als Diffusionssperre zwischen einem kapazitiven und einem induktiven Bereich des Vielschichtbauelements. Durch die metallische Zwischenschicht wird die Diffusion zwischen den beiden Bereichen annähernd vollständig unterbunden. Ohne einer metallhaltigen Zwischenschicht könnten beispielsweise Dotierstoffe aus der Varistorkeramik in die Ferritkeramik diffundieren oder Dotierstoffe der Ferritkeramik in die Varistorkeramik.

Das Vielschichtbauelement umfasst zur Kontaktierung der Elektrodenstruktur und der Innenelektroden des Vielschichtbauelements mehrere Außenkontakte. In einer bevorzugten Ausführungsform sind die Außenkontakte in Array-Form ausgeführt. Hierbei kann es sich um einen Land-Grid-Array (LGA) oder auch um einen Ball-Grid-Array (BGA) handeln.

In einer Ausführungsform weist die Varistorkeramik eine ESD (Electrostatic Discharge) -Schutzfunktion auf.

In einer Ausführungsform weist der kapazitive Bereich des Vielschichtbauelements einen Vielschicht-Keramik-Kondensator auf.

Durch das zuvor beschriebene Vielschichtbauelement ist es möglich, eine ESD-Schutzfunktion und eine Filterfunktion in einem einzelnen Bauteil zu integrieren.

Es ist auch möglich mehrere LC-Filter in einem Bauelement als Array anzuordnen. Dazu werden mehrere LC-Filter beispielsweise nebeneinander in einem gemeinsamen Bauelement angeordnet.

Die oben beschriebenen Gegenstände werden anhand der folgenden Figuren und Ausführungsbeispielen näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein. Elemente, die einander gleichen oder die die gleichen Funktionen übernehmen, sind mit den gleichen Bezugszeichen gezeichnet.
- Figur 1: zeigt einen schematischen Aufbau eines ersten Ausführungsbeispiels eines Vielschichtbauelements,
- Figur 2: zeigt eine dreidimensionale Ansicht eines weiteren Ausführungsbeispiels des Vielschichtbauelements,
- Figur 3: zeigt ein Ersatzschaltbild eines LC-Filters,
- Figur 4: zeigt ein Ersatzschaltbild eines Pi-Typ LC-Filters.

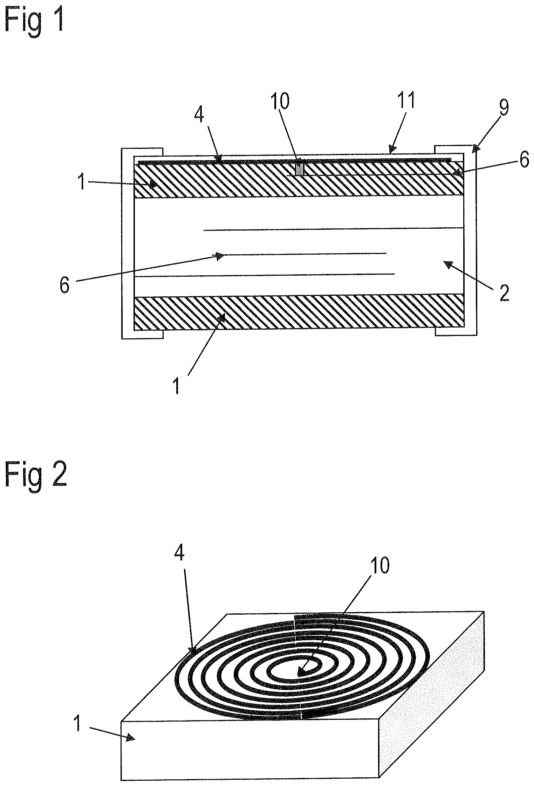

In Figur 1 ist eine schematische Ansicht eines ersten Ausführungsbeispiels eines Vielschichtbauelements dargestellt. Das Vielschichtbauelement weist zwei induktive Bereiche 1 auf, zwischen denen ein kapazitiver Bereich 2 angeordnet ist. Die induktiven Bereiche 1 umfassen vorzugsweise eine Ferrit-Keramik. Der kapazitive Bereich 2 kann eine Varistor- oder eine Kondensatorkeramik umfassen. Der induktive 1 und der kapazitive 2 Bereich weisen jeweils Elektroden auf. Die Elektroden können sowohl innerhalb der Bereiche als Innenelektroden 6 oder als Elektrodenstrukturen 3 auf der Oberseite des induktiven Bereichs 1 vorliegen. Die Innenelektroden 6 des kapazitiven Bereichs 2 bilden wenigstens eine Kapazität 7 und einen nichtlinearen Widerstand. Der induktive Bereich 1 weist auf der nach außen gewandten Oberseite eine Elektrodenstruktur 3 auf, die wenigstens eine Spulenstruktur 4 und wenigstens eine Induktivität 5 bilden. Der induktive Bereich 1 weist weitere Innenelektroden 6 und Durchkontaktierungen 10 auf, die beispielsweise als Zuführungen für die Spulenstruktur 4 und/oder die Induktivität auf der Oberseite des induktiven Bereichs 1 dienen. Die Induktivität des induktiven Bereichs 1 und die Kapazität 7 des kapazitiven Bereichs 2 bilden einen LC-Filter.

Auf der Oberseite des Vielschichtbauelements ist die Spulenstruktur 4 von einer Passivierungsschicht 11 überdeckt. Die Passivierungsschicht 11 dient vorzugsweise zum Schutz der Spulenstruktur 4 vor Korrosion oder anderen schädlichen Einflüssen.

Zwischen dem induktiven Bereich 1 und dem kapazitiven Bereich 2 kann eine metallische Zwischenschicht angeordnet sein, die in dieser Ausführungsform nicht dargestellt ist. Die metallische Zwischenschicht dient als Diffusionssperre zwischen dem induktiven 1 und dem kapazitiven 2 Bereich. Zur Kontaktierung nach außen weist das Vielschichtbauelement mehrere Außenkontakte 9 auf. Die Außenkontakte 9 sind mit den Elektroden des induktiven Bereichs 1 und des kapazitiven Bereichs 2 elektrisch verbunden. Die Varistorkeramik des kapazitiven Bereichs 2 weist vorzugsweise eine ESD-Schutzfunktion auf.

Die Figur 2 zeigt eine dreidimensionale Ansicht eines weiteren Ausführungsbeispiels des Vielschichtbauelements. In dieser Ansicht ist die Spulenstruktur 4 auf der Oberseite des induktiven Bereichs 1 in Form einer kreisförmigen Spirale gezeigt. Die Spulenstruktur 4 kann jedoch auch jede andere geeignete Form aufweisen. Zur Kontaktierung der Spulenstruktur 4 weist der induktive Bereich 1 im Zentrum der Spulenstruktur 4 eine Durchkontaktierung 10 auf. Die Durchkontaktierung 10 verbindet die Spulenstruktur 4 mit weiteren Innenelektroden des induktiven Bereichs 1 oder auch des kapazitiven Bereichs elektrisch miteinander.

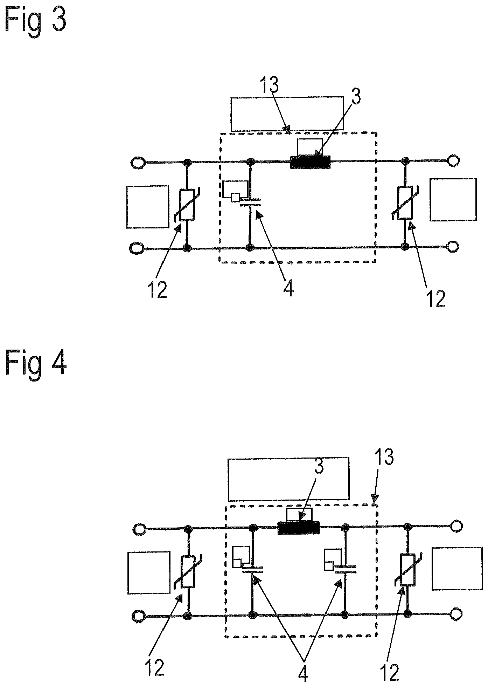

In der Figur 3 ist ein Ersatzschaltbild eines LC-Filters eines Ausführungsbeispiels des Vielschichtbauelements dargestellt. Das Schaltbild zeigt einen LC-Filter 13 bei dem zwei Varistoren 12 jeweils parallel zu einer Kapazität 7 des LC-Filters 13 geschaltet sind. Der LC-Filter 6 besteht aus einer Induktivität 5 und einer Kapazität 7, die parallel zueinander verschaltet sind. Die Induktivität 5 ist in Leitungsrichtung geschaltet. Die Kapazität 7 ist zwischen zwei Leitungen des LC-Filters 13 geschaltet.

Die Figur 4 zeigt ein Ersatzschaltbild eines LC-Filters eines weiteren Ausführungsbeispiels des Vielschichtbauelements. Der LC-Filter 13 hat die Gestalt eines Pi-Typ LC-Filters. Der LC-Filter 13 umfasst eine Induktivität 5 und zwei parallel zur Induktivität 5 geschaltete Kapazitäten 7. Parallel zu den Kapazitäten 7 des LC-Filters 6 sind zwei Varistoren 12 geschaltet, die als ESD-Schutzelemente für den LC-Filter 13 dienen.

Obwohl in den Ausführungsbeispielen nur eine beschränkte Anzahl möglicher Weiterbildung der Erfindung beschrieben werden konnte ist die Erfindung nicht auf diese beschränkt. Es ist prinzipiell möglich, dass das Vielschichtbauelement eine höhere Anzahl an Keramikbereichen aufweist.

Die Erfindung ist nicht auf die Anzahl der dargestellten Elemente beschränkt.

Die Beschreibung der hier angegebenen Gegenstände ist nicht auf die einzelnen speziellen Ausführungsformen beschränkt vielmehr können die Merkmale der einzelnen Ausführungsformen soweit technisch sinnvoll beliebig miteinander kombiniert werden.

### Bezugszeichenliste

- 1: induktiver Bereich
- 2: kapazitiver Bereich
- 3: Elektrodenstruktur
- 4: Spulenstruktur
- 5: Induktivität
- 6: Innenelektrode
- 7: Kapazität
- 9: Außenkontakt
- 10: Durchkontaktierung
- 11: Passivierungsschicht
- 12: Varistor
- 13: LC-Filter

## Patentansprüche

1. Vielschichtbauelement, aufweisend
- wenigstens einen induktiven Bereich (1),
- wenigstens einen kapazitiven Bereich (2),
- wobei der kapazitive Bereich (2) eine Varistorkeramik oder eine Kondensatorkeramik umfasst,
- wobei der kapazitive Bereich (2) Innenelektroden (6) aufweist, die wenigstens eine Kapazität (7) und wenigstens einen nichtlinearen Widerstand umfassen,
- wobei der induktive Bereich (1) eine Ferrit-Keramik umfasst,
- wobei auf der nach außen gewandten Oberseite des induktiven Bereichs (1) Elektrodenstrukturen (3) angeordnet sind,
- wobei die Elektrodenstrukturen (3) wenigstens eine Spulenstruktur (4) bilden, welche eine Induktivität (5) aufweist.

2. Vielschichtbauelement nach Anspruch 1, wobei die Spulenstruktur (4) die Form einer Spirale aufweist.

3. Vielschichtbauelement nach einem der Ansprüche 1 oder 2, wobei die Spulenstruktur (4) Cu, Ag, Pd, oder Pt umfasst.

4. Vielschichtbauelement nach einem der Ansprüche 1 bis 3, wobei die Spulenstruktur (4) von einer Passivierungsschicht (11) überdeckt ist.

5. Vielschichtbauelement nach einem der Ansprüche 1 bis 4, wobei die Ferrit-Keramik NiZn-Ferrite, NiCuZn-Ferrite oder NiZnCo-Ferrite umfasst.

6. Vielschichtbauelement nach einem der Ansprüche 1 bis 4, wobei die Ferrit-Keramik hexagonale Ferrite umfasst.

7. Vielschichtbauelement nach einem der Ansprüche 1 bis 6, wobei die Varistor-Keramik eine Zno-Bi-Sb Keramik oder eine ZnO-Pr Keramik umfasst.

8. Vielschichtbauelement nach einem der Ansprüche 1 bis 7, wobei die Kondensator-Keramik eine NPO Keramik umfasst.

9. Vielschichtbauelement nach einem der Ansprüche 1 bis 8, wobei die wenigstens eine Induktivität (5) und die wenigstens eine Kapazität (7) eine T-LC Filterstruktur oder eine Pi-LC Filterstruktur bilden.

10. Vielschichtbauelement nach einem der Ansprüche 1 bis 9, wobei zwischen dem induktiven Bereich (1) und dem kapazitiven Bereich (2) eine metallische Schicht angeordnet ist, die als Diffusionssperre zwischen dem induktiven Bereich (1) und dem kapazitiven Bereich (2) dient.

11. Vielschichtbauelement nach einem der Ansprüche 1 bis 10, wobei das Vielschichtbauelement Außenkontakte (9) aufweist, die als LGA, BGA oder als Array ausgeführt sind.

12. Vielschichtbauelement nach einem der Ansprüche 1 bis 11, wobei die Varistorkeramik eine ESD-Schutzfunktion aufweist.

## Claims

1. Multilayer component, comprising
- at least one inductive region (1),
- at least one capacitive region (2),
- wherein the capacitive region (2) comprises a varistor ceramic or a capacitor ceramic,
- wherein the capacitive region (2) has internal electrodes (6) comprising at least one capacitance (7) and at least one nonlinear resistance,
- wherein the inductive region (1) comprises a ferrite ceramic,
- wherein electrode structures (3) are arranged on the outwardly facing top side of the inductive region (1),
- wherein the electrode structures (3) form at least one coil structure (4) having an inductance (5).

2. Multilayer component according to Claim 1, wherein the coil structure (4) has the form of a spiral.

3. Multilayer component according to either of Claims 1 and 2, wherein the coil structure (4) comprises Cu, Ag, Pd, or Pt.

4. Multilayer component according to any of Claims 1 to 3, wherein the coil structure (4) is covered by a passivation layer (11).

5. Multilayer component according to any of Claims 1 to 4, wherein the ferrite ceramic comprises NiZn ferrites, NiCuZn ferrites or NiZnCo ferrites.

6. Multilayer component according to any of Claims 1 to 4, wherein the ferrite ceramic comprises hexagonal ferrites.

7. Multilayer component according to any of Claims 1 to 6, wherein the varistor ceramic comprises a ZnO-Bi-Sb ceramic or a ZnO-Pr ceramic.

8. Multilayer component according to any of Claims 1 to 7, wherein the capacitor ceramic comprises an NPO ceramic.

9. Multilayer component according to any of Claims 1 to 8, wherein the at least one inductance (5) and the at least one capacitance (7) form a T-LC filter structure or a Pi-LC filter structure.

10. Multilayer component according to any of Claims 1 to 9, wherein a metallic layer is arranged between the inductive region (1) and the capacitive region (2), said metallic layer serving as a diffusion barrier between the inductive region (1) and the capacitive region (2).

11. Multilayer component according to any of Claims 1 to 10, wherein the multilayer component comprises external contacts (9) embodied as LGA, BGA or as an array.

12. Multilayer component according to any of Claims 1 to 11, wherein the varistor ceramic has an ESD protection function.

## Revendications

1. Composant multicouche, comportant
- au moins une zone inductive (1),
- au moins une zone capacitive (2),
- dans lequel la zone capacitive (2) comprend une céramique de varistance ou une céramique de condensateur,
- dans lequel la zone capacitive (2) comporte des électrodes internes (6) qui comprennent au moins une capacité (7) et au moins une résistance non linéaire,
- dans lequel la zone capacitive (1) comprend une céramique de ferrite,
- dans lequel des structures d'électrodes (3) sont disposées sur la face supérieure tournée vers l'extérieur de la zone inductive (1),
- dans lequel des structures d'électrodes (3) forment au moins une structure de bobine (4) qui présente une inductance (5).

2. Composant multicouche selon la revendication 1, dans lequel la structure de bobine (4) présente la forme d'une spirale.

3. Composant multicouche selon l'une quelconque des revendications 1 ou 2, dans lequel la structure de bobine (4) comprend du Cu, de l'Ag, du Pd ou du Pt.

4. Composant multicouche selon l'une quelconque des revendications 1 à 3, dans lequel la structure de bobine (4) est recouverte par une couche de passivation (11).

5. Composant multicouche selon l'une quelconque des revendications 1 à 4, dans lequel la céramique de ferrite comprend des ferrites de NiZn, des ferrites de NiCuZn, ou des ferrites de NiZnCo.

6. Composant multicouche selon l'une quelconque des revendications 1 à 4, dans lequel la céramique de ferrite comprend des ferrites hexagonales.

7. Composant multicouche selon l'une quelconque des revendications 1 à 6, dans lequel la céramique de varistance comprend une céramique de ZnO-Bi-Sb ou une céramique de ZnO-Pr.

8. Composant multicouche selon l'une quelconque des revendications 1 à 7, dans lequel la céramique de condensateur comprend une céramique de NPO.

9. Composant multicouche selon l'une quelconque des revendications 1 à 8, dans lequel l'au moins une inductance (5) et l'au moins une capacité (7) forment une structure de filtre T-LC ou une structure de filtre Pi-LC.

10. Composant multicouche selon l'une quelconque des revendications 1 à 9, dans lequel une couche métallique qui sert de barrière de diffusion entre la zone inductive (1) et la zone capacitive (2) est disposée entre la zone inductive (1) et la zone capacitive (2).

11. Composant multicouche selon l'une quelconque des revendications 1 à 10, dans lequel le composant multicouche comporte des contacts extérieurs (9) qui sont réalisés sous la forme d'un LGA, d'un BGA ou d'un réseau.

12. Composant multicouche selon l'une quelconque des revendications 1 à 11, dans lequel la céramique de varistance présente une fonction de protection ESD.
